# EUROPEAN PATENT APPLICATION

(11) **EP 4 253 987 A1**
(43) Date of publication of application: **04.10.2023**
(21) Application number: 22165794.3
(22) Date of filing: 31.03.2022
(51) Int. Cl.: G01R 33/565, G01R 33/54, G01R 33/567

(54) **CONTROLLING MAGNETIC RESONANCE IMAGING**

(71) Applicant: Koninklijke Philips N.V., 5656 AG Eindhoven (NL)
(72) Inventor: SENEGAS, Julien, Eindhoven (NL); SOMMER, Karsten, Eindhoven (NL); KRUEGER, Sascha, Eindhoven (NL); MAZURKEWITZ, Peter Caesar, Eindhoven (NL)
(74) Representative: Philips Intellectual Property & Standards

(57) **Abstract**

Proposed concepts thus aim to provide schemes, solutions, concept, designs, methods and systems pertaining to controlling MRI examination of a subject. In particular, embodiments aim to determining control parameters and/or control instructions for the MRI examination of the subject based on motion of the subject during the preparation phase of the MRI examination. The motion of the subject during the preparation phase may be obtained from video of the subject captured during the preparation phase.

## Description

### FIELD OF THE INVENTION

This invention relates to the field of Magnetic Resonance Imaging (MRI), and particularly to controlling magnetic resonance imaging, MRI, examination of a subject.

### BACKGROUND OF THE INVENTION

Producing high quality magnetic resonance images of a subject requires the subject to remain still (i.e. motionless) during an MRI scan. For example, when a subject's head moves within the magnetic bore of the MRI scanner, the magnetic susceptibility field will also move, leading to degradation of image quality. Degradation of image quality due to patient motion is therefore one of the most frequent problems in the clinical application of MRI. Many subject have difficulties remaining calm (and therefore motionless) throughout an entire MRI scan. In most cases, however, occurrence of patient motion is detected relatively late in the workflow, i.e. during or even at the end of the MRI scan.

A particularly problematic example of motion-prone MRI scans are sequences involving multiple breath-hold (BH) manoeuvres. For these scans, an operator is typically required to choose a number of consecutive BH manoeuvres to be performed by the subject being examined, as well as the corresponding pauses that are suitable for the subject. This assessment is typically difficult, because it requires knowledge of the cardiorespiratory fitness level of the subject for example.

When subject motion is detected (usually late in the MRI scan process), some countermeasures are known, such as modifying sequences, patient instructions or immobilization strategies (e.g. additional cushions). However, taking such countermeasures can cause substantial delays in the MRI scan workflow. Also, for MRI scans involving multiple BH manoeuvres, repetition of the sequence with adjusted settings may not be possible, e.g. many subjects cannot recover quickly from previous breath-hold manoeuvres. Yet further, MRI scans requiring contrast-agent injection cannot be repeated.

### SUMMARY OF THE INVENTION

The invention is defined by the claims.

According to examples in accordance with an aspect of the invention, there is provided a method for controlling MRI examination of a subject.

The method comprises: obtaining video data from captured video of the subject during a preparation phase of an MRI examination; processing the video data with a motion detection algorithm to obtain motion data describing motion of the subject during the preparation phase of the MRI examination; and determining at least one of control parameters and control instructions for the MRI examination of the subject based on the motion data.

Proposed concepts thus aim to provide schemes, solutions, concept, designs, methods and systems pertaining to controlling MRI examination of a subject. In particular, embodiments aim to determining control parameters and/or control instructions for the MRI examination of the subject based on motion of the subject during the preparation phase of the MRI examination. The motion of the subject during the preparation phase may be obtained from video of the subject captured during the preparation phase.

In other words, it is proposed that captured video of the subject during a preparation phase of an MRI examination may be analysed to obtain motion data that can then be leveraged to control parameters and/or control instructions for the MRI examination.

For instance, by automatically analysing subject motion during MRI exam preparation using a video camera, observed motion patterns can be translated into: (a) recommendations for the MRI operator; (b) automatic adjustments of the planned examination sequences; or (c) constraints that are used to boost retrospective motion correction techniques during image reconstruction. As a result, image degradation due to subject motion may be reduced or mitigated. Ultimately, high quality magnetic resonance images of the subject, with fewer artefacts, may be obtained by the proposed concept(s).

Images obtained from MRI controlled according to the proposed concept(s) may aid clinical decision making. Accordingly, embodiments may be used in relation to supporting a medical professional when selecting treatment for a subject. Such embodiments may also support clinical planning. Improved Clinical Decision Support (CDS) may therefore be provided by proposed concepts.

In some embodiments, determining at least one of control parameters and control instructions may comprise processing the motion data with a translation algorithm so as to translate the motion data to a least one of a control parameter and control instruction for the MRI examination of the subject. For example, motion data may be compared with a large database/dictionary of previously acquired data comprising corresponding measures of cardiorespiratory fitness level. In this way, based on obtained motion data, control parameters and control instructions for the MRI examination may be looked up in a database (or other form of repository). Simple techniques to convert or translate motion data to control parameters and/or control instructions for the MRI examination may therefore be employed by proposed embodiments.

Some embodiments may further comprise obtaining vital sign data describing one or more vital signs of the subject before/during the MRI examination. Determining control parameters and/or control instructions for the MRI examination of the subject may then be further based on the vital sign data. For example, obtaining vital sign data may comprise monitoring the subject's pulse and determining a heart rate of the subject before/during the MRI examination. In this way, control parameters and/or control instructions for the MRI examination may be further adapted (i.e. tailored) to the subject. By analysing and accounting for vital signs of the subject, more accurate determinations and decisions may be achieved.

Some embodiments may further comprise obtaining subject data describing one or more physiological parameters of the subject, and wherein determining control parameters and/or control instructions for the MRI examination of the subject is further based on the subject data. That is, control parameters and/or control instructions for the MRI examination may be further adapted (i.e. tailored) to physical characteristics or traits of the subject, thus improving accuracy of determinations.

In some proposed embodiments, the process of obtaining video data may comprise: instructing the subject to perform a plurality of consecutive breath-hold (BH) manoeuvres; and obtaining video data from captured video of the subject performing the plurality of consecutive BH manoeuvres. Processing the video data may then comprise processing the video data with a motion detection algorithm to obtain motion data describing motion of the subject during the plurality of consecutive BH manoeuvres. Further, determining control parameters and/or control instructions may then comprise: determining a BH capability of the subject based on the motion data; and generating a control instruction for setting at least one of: a number of BH manoeuvres to be instructed during the MRI examination; a BH recovery time; and a maximum duration of the MRI examination. In this way, for multi-BH examinations/scans, a simple BH experiment may be performed during the preparation phase to determine the cardiorespiratory fitness level and facilitate personalized examination/scan adjustment. For instance, such a BH experiment may be undertaken in the preparation phase while analysing one or more of the subject's vital sign and breathing pattern so as to identify a BH capability of the subject.

Further, in some embodiments, determining a BH capability of the subject may comprise: providing the motion data as in input to a machine-learning algorithm, the machine-learning algorithm being trained to predict, for the subject associated with the motion data, a BH value indicating a BH capability of the subject. For example, the BH value comprises at least one of: a maximum number of achievable BH manoeuvres; a maximum achievable BH length; and a BH recovery time.

The machine-learning algorithm may, for example, be trained using a training algorithm configured to receive an array of training inputs and respective known outputs, wherein a training input comprises motion data associated with a subject and respective known output comprises a BH value indicating a breath-hold capability of the subject. In this way, the machine learning algorithm may be trained to output a breath-hold capability prediction for a subject when provided with motion data describing motion of the subject during the preparation phase of the MRI examination.

In some embodiments, determining at least one of control parameters and control instructions may comprise: determining, based on the motion data, a motion severity value describing a severity of the motion of the subject during the preparation phase of the MRI examination; and
determining, based on the motion severity value, a first motion compensation value for a motion compensation algorithm of the MRI examination. A severity or amount of subject motion may therefore also be accounted for, thus improving accuracy of a control parameter or control instruction.

In an embodiment, determining at least one of control parameters and control instructions may comprise: determining, based on the motion data, a motion pattern value describing a pattern of motion of the subject during the preparation phase of the MRI examination; and determining, based on the motion pattern value, a second motion compensation value for a motion compensation algorithm of the MRI examination. In this way, a pattern of movement of the subject may be identified and predicted to occur during MRI examination. The predicted movement may then be compensated for (e.g. accounted for or corrected) in image(s) acquired during the MRI examination.

In yet another embodiment, determining at least one of control parameters and control instructions may comprise: determining, based on the motion data, an instruction for an operator of the MRI examination. For example, such an embodiment may communicate instructions for setting or altering MRI scan parameters and/or instructions for supervising/guiding the subject.

The motion detection algorithm may, for example, employ a neural network, the neural network being trained to predict, for input video data from captured video of a subject, one or more anatomical landmarks of the subject. The motion detection algorithm may then be configured to a determine a region of interest, ROI, of the subject based on a prediction result from the neural network and to determine motion data describing motion of the ROI of the subject based on the video data. For example, video data from a camera may be processed to locate relevant, pre-defined anatomical landmarks, e.g. using a convolutional neural network (CNN), from which a ROI for obtaining the subject's breathing may be identified. The identified ROI may then be analysed in connection with corresponding depth images captured by the camera so as calculate a breathing motion of the subject, e.g. by averaging depth pixel values in the ROI. However, various other known video/image processing and/or motion detection techniques may be employed to obtain an accurate determination of breathing motion of the subject from input video data.

Some embodiments may further include a process of reconstructing an MRI image of the subject acquired during the MRI examination retrospectively based on the motion data.

According to examples in accordance with an aspect of the invention, there is provided a computer program comprising code means for implementing an embodiment of the proposed method when said program is run on a processing system.

According to another aspect, there is provided a computer program product for controlling MRI examination of a subject, wherein the computer program product comprises a computer-readable storage medium having computer-readable program code embodied therewith, the computer-readable program code configured to perform all of the steps of a proposed embodiment. Thus, there may also be provided a computer system comprising: a computer program product according to proposed embodiment; and one or more processors adapted to perform a method according to a proposed concept by execution of the computer-readable program code of said computer program product.

According to another aspect of the invention, there is provided a system for controlling MRI examination of a subject. The system comprises:
an input interface configured to obtain video data from captured video of the subject during a preparation phase of an MRI examination;
a processor arrangement configured to process the video data with a motion detection algorithm to obtain motion data describing motion of the subject during the preparation phase of the MRI examination; and
a data analysis unit configured to determine control instructions for MRI examination of the subject based on the motion data.

The system may be remotely located from a user device for controlling MRI examination of a subject. In this way, a user (such as a medical professional) may have an appropriately arranged system that can receive information at a location remotely located from the system for controlling MRI examination of a subject. Embodiments may therefore enable a user to dynamically modify an MRI examination using a local system (which may, for example, comprise a portable display device, such as a laptop, tablet computer, mobile phone, PDA, etc.). By way of example, embodiments may provide an application for a mobile computing device, and the application may be executed and/or controlled by a user of the mobile computing device.

The system may further include: a server device comprising the system for controlling MRI examination of a subject; and a client device comprising a user-interface. Dedicated data processing means may therefore be employed for the purpose of controlling MRI examination of a subject, thus reducing processing requirements or capabilities of other components or devices of the system.

The system may further include a client device, wherein the client device comprises the input interface, processor arrangement, data analysis unit and a display unit. In other words, a user (such as a doctor, medical professional, or MRI technician) may have an appropriately arranged client device (such as a laptop, tablet computer, mobile phone, PDA, etc.) which processes received data in order to determine at least one of control parameters and control instructions for MRI examination of a subject and to generate a display control signal. Purely by way of example, embodiments may therefore provide a MRI control system that enables adaptation of MRI examinations of subjects (e.g. patients) from a single, remote location, wherein real-time communication between the MRI apparatus and monitoring user (e.g. doctor, medical professional, or MRI technician) is provided and can have its functionality extended or modified according to proposed concepts, for example.

It will be understood that processing capabilities may therefore be distributed throughout the system in different ways according to predetermined constraints and/or availability of processing resources.

Embodiments may be employed in combination with conventional/existing MRI apparatus. In this way, embodiments may integrate into legacy MRI systems so as to improve and/or extend functionality and capabilities. An MRI system may therefore be provided by proposed embodiments.

Thus, there may be proposed concepts for controlling (e.g. modifying, adapting or tailoring) MRI examination of a subject, and this may done based on visually-observed motion of the subject during a preparation phase of the MRI examination. Facilitating such adaptation of an MRI examination may help to improve image quality, whilst also reducing a time taken and/or the resources required for improved MRI examination.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Fig. 1 is a flow diagram of an exemplary embodiment of a method for controlling MRI examination of a subject;
Fig. 2 is a simplified block diagram of another exemplary embodiment of a method for controlling MRI examination of a subject;
Fig. 3 is a simplified block diagram of yet another exemplary embodiment of a method for controlling MRI examination of a subject;
Fig. 4 is a simplified block diagram of a system for controlling MRI examination of a subject according to an embodiment; and
Fig. 5 illustrates an example of a computer within which one or more parts of an embodiment may be employed

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

It should be understood that the Figures are merely schematic and are not drawn to scale. It should also be understood that the same reference numerals are used throughout the Figures to indicate the same or similar parts.

Implementations in accordance with the present disclosure relate to various techniques, methods, schemes and/or solutions pertaining to controlling MRI examination of a subject. According to proposed concepts, a number of possible solutions may be implemented separately or jointly. That is, although these possible solutions may be described below separately, two or more of these possible solutions may be implemented in one combination or another.

Embodiments of the invention aim to determine control parameters and control instructions for the MRI examination of the subject by analysing motion (i.e. movement) of the subject during the preparation phase of an MRI examination. This can be achieved by processing captured video of the subject with a motion detection algorithm to obtain motion data describing motion of the subject during the preparation phase of the MRI examination.

Embodiments may also provide a system for prospective adaptation and/or correction of a MRI examination according to observed subject motion. The system may actively capture motion data by monitoring the motion of the subject in captured video of the subject.

Proposed concepts thus aim to control MRI examination of a subject by determining control parameters and/or control instructions for the MRI based on motion of the subject during the preparation phase of the MRI examination. The motion of the subject during the preparation phase may be obtained from video of the subject captured during the preparation phase. Put another way, it is proposed that captured video of the subject during a preparation phase of an MRI examination may be processed/analysed to obtain motion data that can then be leveraged to control parameters and/or control instructions for the MRI examination.

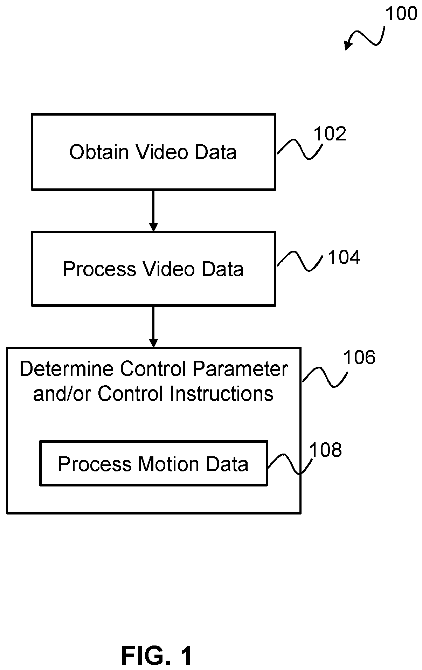

Referring now to Fig. 1, there is depicted a flow diagram of an exemplary embodiment of a method 100 for controlling magnetic resonance imaging, MRI, examination of a subject.

The method begins with the step 102 of obtaining video data from captured video of the subject during a preparation phase of an MRI examination. In this exemplary embodiment, the video of the subject is captured by a RGB/Depth camera (e.g. ceiling/wall mounted video camera) that is adapted to provide a continuous video stream of the subject table of the MRI apparatus.

In step 104, the video data is processed with a motion detection algorithm to obtain motion data describing motion of the subject during the preparation phase of the MRI examination. Specifically, the motion detection algorithm of this exemplary embodiment employs a neural network, the neural network being trained to predict, for input video data from the captured video of a subject, one or more anatomical landmarks of the subject. In particular, the colour data stream of the capture video is first processed using a dedicated Convolutional Neural Network (CNN) to locate relevant predetermined anatomical landmarks of the subject's body. Using these landmarks, a Region of Interest (ROI) for obtaining the subject's breathing signal is identified (e.g. calculated). Put another way, the motion detection algorithm is configured to determine a ROI of the subject based on a prediction result from the CNN.

The structure of an artificial neural network (or, simply, neural network) is inspired by the human brain. Neural networks are comprised of layers, each layer comprising a plurality of neurons. Each neuron comprises a mathematical operation. In particular, each neuron may comprise a different weighted combination of a single type of transformation (e.g. the same type of transformation, sigmoid etc. but with different weightings). In the process of processing input data, the mathematical operation of each neuron is performed on the input data to produce a numerical output, and the outputs of each layer in the neural network are fed into the next layer sequentially. The final layer provides the output.

There are several types of neural network, such as convolutional neural networks (CNNs) and recurrent neural networks (RNNs). This exemplary embodiment of the present invention employs CNN-based learning algorithms, becuase CNNs have proved to be particularly successful at analyzing images, and are able to classify images with a much lower error rate than other types of neural network.

CNNs typically contain several layers, including a convolutional layer, a pooling layer, and a fully connected layer. The convolutional layer consists of a set of learnable filters and extracts features from the input. The pooling layer is a form of non-linear down-sampling, reducing the data size by combining the outputs of a plurality of neurons in one layer into a single neuron in the next layer. The fully connected layer connects each neuron in one layer to all the neurons in the next layer.

Methods of training a machine-learning algorithm are well known. Typically, such methods comprise obtaining a training dataset, comprising training input data entries and corresponding training output data entries. An initialized machine-learning algorithm is applied to each input data entry to generate predicted output data entries. An error between the predicted output data entries and corresponding training output data entries is used to modify the machine-learning algorithm. This process can be repeated until the error converges, and the predicted output data entries are sufficiently similar (e.g. ±1%) to the training output data entries. This is commonly known as a supervised learning technique.

For example, weightings of the mathematical operation of each neuron may be modified until the error converges. Known methods of modifying a neural network include gradient descent, backpropagation algorithms and so on.

The training input data entries for the CNN-based learning algorithm used in method 100 correspond to example digital video data or high quality video images of a subject on the subject table of the MRI apparatus during a preparation phase of an MRI examination. The training output data entries correspond to anatomical landmarks of a subject's body. Also, several pre-processing methods may be employed to improve the training sampleSs). Video/images from the same MRI facility and the same MRI system may be normalized in display features such as gamma correction, for example.

The predicted ROI is region is then used to analyse depth images from the captured video, and the breathing signal (i.e. motion data) of the subject is calculated, e.g. by simply averaging the depth pixel values in the ROI. However, it is to be understood that more sophisticated and robust techniques to obtain an accurate breathing signal may also be used.

The obtained motion data (e.g. breathing signal) is then analysed in step 106 to determining a control parameter and/ control instruction for the MRI examination of the subject. More specifically, in the exemplary embodiment of Fig. 1, the step 106 of comprises processing the motion data with a translation algorithm so as to translate the motion data to a control parameter or control instruction for the MRI examination of the subject. For this, a database or lookup table may be employed to identify a control parameter or control instruction corresponding to one or more value(s) of the breathing signal. For instance, a value of the breathing signal (e.g. respiration rate) may be compared with a database/dictionary of previously obtained data having corresponding measures of cardiorespiratory fitness level that may be communicated to the MRI apparatus (and/or an operator of the MRI apparatus). Based on an identified cardiorespiratory fitness level of the subject, the MRI apparatus (or its operator) may adapt, modify or tailor an MRI examination of the subject. That is, based on the obtained motion data, control parameters and control instructions for the MRI examination may be looked up in a database (or other form of repository), thus translating motion data to a control parameter and/or control instruction for the MRI examination of the subject.

Although the above-described embodiment of Fig. 1 is detailed as employing motion data to determine a control parameter and/or control instruction for the MRI examination, other embodiments may employ further information/data about the subject to refine or improve a determination of a control parameter and/or control instruction.

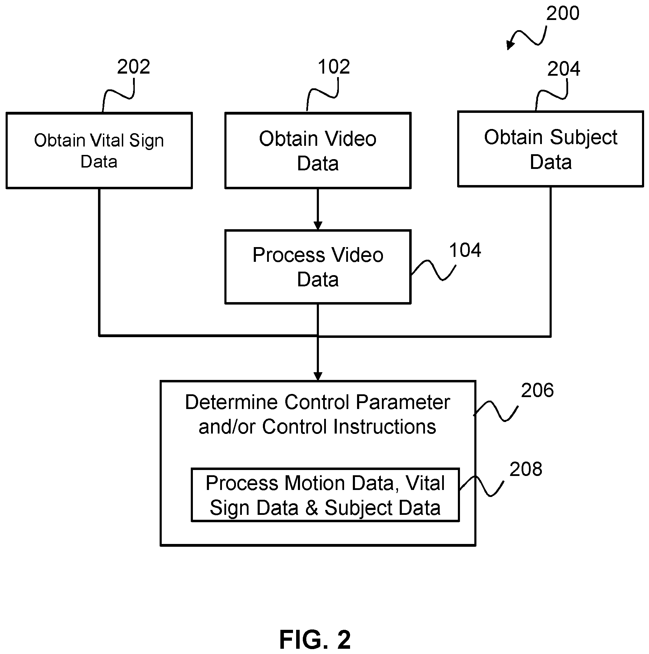

By way of example, Fig. 2 depicts a flow diagram of another proposed embodiment, which comprises a modification to the embodiment of Fig. 1.

Specifically, Fig. 2 depicts a method 200 for controlling MRI examination of a subject that is similar to the method 100 of Fig. 1, but further employs: information regarding vital signs of the subject; and subject data describing one or more physiological parameters of the subject.

In particular, the method 200 includes the additional step 202 of obtaining vital sign data describing one or more vital signs of the subject before/during the MRI examination. Here, obtaining vital sign data comprises monitoring the subject's pulse and determining a heart rate of the subject before/during the MRI examination. Furthermore, the patient's heart rate (HR) may be tracked using photoplethysmography (PPG), wherein extraction of the heart rate from the PPG signal is performed using known/conventional algorithms. To this end, predicted/detected anatomical landmarks may be used to find locations with suitable image ROIs such as the face.

The method 220 also includes the extra step 204 of obtaining subject data describing one or more physiological parameters of the subject (such as gender, age, weight, etc.) This may be obtained directly from electronic records stored in a remotely accessible database, for example. Alternatively, or additionally, subject data may be obtained by a user entering values of parameters into a user interface.

To take account of the additional data obtained from steps 202 and 204, the step 206 of wherein determining at least one of control parameters and control instructions for MRI examination of the subject is further based on the subject data and the vital sign data. In this way, the method 200 of Fig. 2 employs additional data about the subject to increase prediction accuracy.

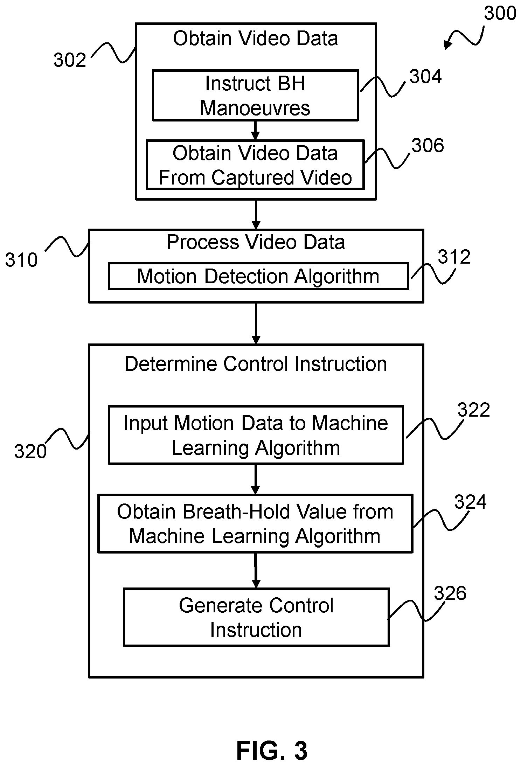

Referring now to Fig. 3, there is depicted a flow diagram of yet another embodiment of the invention. In this exemplary embodiment, to assess the subject's cardiorespiratory fitness level, and thereby his/her ability to perform consecutive BH manoeuvres, a BH experiment is performed during the preparation phase of the MRI examination. During the BH experiment, the respiratory and cardiac signals are continuously analysed using the captured video of the subject (e.g. from a wall/ceiling mounted video camera).

The method begins with the step 302 of obtaining video data from captured video of the subject during a preparation phase of an MRI examination. Here, the process of obtaining video data comprises sub-steps 304 and 306. In step 304, the subject is instructed to perform a plurality of consecutive BH manoeuvres. The instructions to perform the BH manoeuvres can either be played automatically or be provided/performed by the operator of the MRI apparatus. Then, in step 306, video data is obtained from captured video of the subject performing the plurality of consecutive BH manoeuvres.

The video data is then processed in step 310 with a motion detection algorithm to obtain motion data describing motion of the subject during the preparation phase of the MRI examination. The processing 310 comprises processing 312 the video data with a motion detection algorithm to obtain motion data describing motion of the subject during the plurality of consecutive BH manoeuvres. In this way, captured movement of the subject during performance of the BH manoeuvres is converted/translated into motion data.

In step 320, control parameters and/or control instructions for the MRI examination of the subject are determined based on the motion data from step 310. Specifically, step 320 comprises sub-steps 322, 324 and 326 which perform analysis of the motion data to derive an expected breath-hold capability of the subject and then generate a control parameter or control instruction for MRI examination of the subject.

Step 322 comprises providing the motion data as input to a machine-learning algorithm that is trained to predict, for the subject associated with the motion data, a BH value indicating a BH capability of the subject. By way of example, a BH value may comprise at least one of: a maximum number of achievable BH manoeuvres; a maximum achievable BH length; and a BH recovery time. The machine-learning algorithm is trained using a training algorithm configured to receive an array of training inputs and respective known outputs, wherein a training input comprises motion data associated with a subject and respective known output comprises a BH value indicating a BH capability of the subject.

Step 324 then comprises obtaining a predicted BH value for the subject from the machine learning according to the input motion data. This predicted BH value is then analysed in step 326 in order to generate a control instruction for setting at least one of: a number of BH manoeuvres to be instructed during the MRI examination; a BH recovery time; and a maximum duration of the MRI examination.

In this way, a parameter or control instruction for MRI examination of the subject is provided for adjusting the MRI examination to contain as few BHs as possible (e.g. to improve patient comfort) while maximizing image quality and limiting scan time to a pre-defined length. Furthermore, preference(s) for these targets may be entered by the operator. If the resulting multi-BH sequence exceeds acceptable scan times, alternatives such as free-breathing navigator-based sequences or reduced number of total scans can be offered to the operator.

Differing implementations of the preceding embodiment are also proposed. For instance, the following examples may be employed:
- If it is concluded that the observed BH represents the maximally achievable BH length, subsequent BHs may be assumed to be reduced in length by an empirically determined factor. The recovery period between BHs can then be increased in duration by another empirically determined factor;
- A dictionary-based approach may be used, wherein the observed breathing and HR patterns are matched to a large database/dictionary of previously acquired patterns. A measure of the cardiorespiratory fitness level and/or the maximum number of BHs may be associated with each entry in the database/dictionary, thus enabling conversation/translation of observed patterns to a parameter value or instruction for the MRI examination;
- A neural network may be trained to predict, based on input breathing and HR patterns as an input, the achievable number of BHs as well as their durations and the required recovery time after.

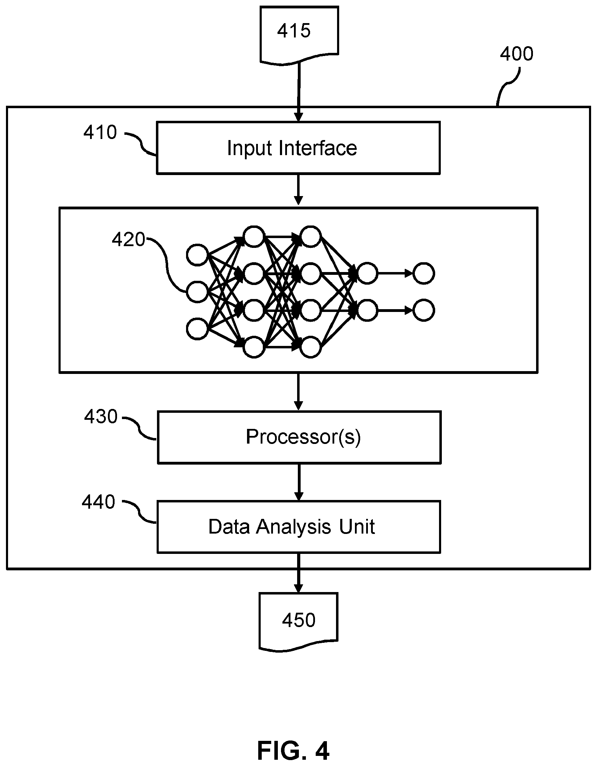

Referring now to Fig. 4, there is depicted a simplified block diagram of a system 400 according to an embodiment. The system 400 configured for controlling MRI examination of a subject and comprises an input interface 410, one or more processors 430 and a data analysis unit 440.

The system 400 is configured to analyse a subject's motion patterns during an MRI examination preparation phase. The subject's motion patterns are obtained from video 415 of the subject captured during the preparation phase of the MRI examination. The system outputs a control signal 450 comprising control parameters and/or control instructions for MRI examination of the subject. The control signal 450 is generated based on the analysis results and is for reducing (bulk) motion artefacts during the MR examination of the subject.

In more detail, the input interface 410 receives video data 415 from captured video of the subject during a preparation phase of an MRI examination. The input interface 410 provides the video data 415 to a CNN 420 for predicting/locating relevant anatomical landmarks of the subject's body within the video data. This facilitate motion pattern analysis on a target anatomy of the subject. Based on the identified anatomical landmarks, the processor(s) 430 then process the video data with a motion detection algorithm to obtain motion data describing motion of the subject during the preparation phase of the MRI examination. For this, a multi-person detection network may be used to avoid external disturbances (e.g. from the operator) by focusing on patient motion only. In addition, analysis of detected landmarks throughout the entire data stream may be used to discard irrelevant parts of the exam preparation, such as the process of helping the patient onto the table. Motion patterns of the subject can thus be realized by tracking changes of the target anatomy's landmark coordinates. If the target anatomy is not directly related to a single anatomical landmark, the closest corresponding landmarks may be used instead.

The resulting motion data (e.g. motion traces and/or patterns) are then processed by the data analysis unit 440 that produces:
(i) Recommendations for the MRI operator, e.g. placement of additional cushions for immobilization, additional patient instructions, etc.;
(ii) Control parameters (i.e. automatic adjustments) for the examination's planned MR sequences. For example, techniques such as MultiVane, navigator-based prospective motion correction or additional NSAs can be added to the exam. Alternatively, sequences that are known to be sensitive to motion can be replaced by more robust scans. For this part, a detected motion pattern can be taken into account: MultiVane e.g. is known to be most effective if the observed patient movement corresponds to in-plane motion for the planned sequences;
(iii) Prior information to boost retrospective motion correction. The detected motion patterns can be translated into constraints that are used to guide the corresponding optimization algorithm. As an example, if a head tremor is observed in the video from the video camera, the solution space of the motion correction algorithm may be restricted to periodic functions in the observed frequency range. In an alternative implementation, the pattern and/or severity of the observed motion may be used to adjust motion compensation algorithm settings, such as selecting a larger initial step size for large motion amplitudes for example.

Above-mentioned approaches may also be employed using an in-bore camera that provides a video stream of the patient during the MRI examination. Subject motion and physiology signals may be continuously monitored and used to adapt the generated control parameters and/or instructions. This may be beneficial, because the in-bore environment is known to cause anxiety or claustrophobia in subjects, potentially requiring an update of the MRI examination planning.

In yet another embodiment, the BH experiment to determine the cardiorespiratory fitness level may also be performed inside the MRI scanner, e.g. during the pre-scans or survey that are usually performed at the beginning of the exam. This has the advantage that total exam time may be not affected.

Yet further, embodiments may also comprise reconstructing an MRI image of the subject acquired during the MRI examination retrospectively based on the motion data. That is, embodiments may be employed retrospectively to reconstruct previously-generated MRI images based on newlydetermined control parameters, for example.

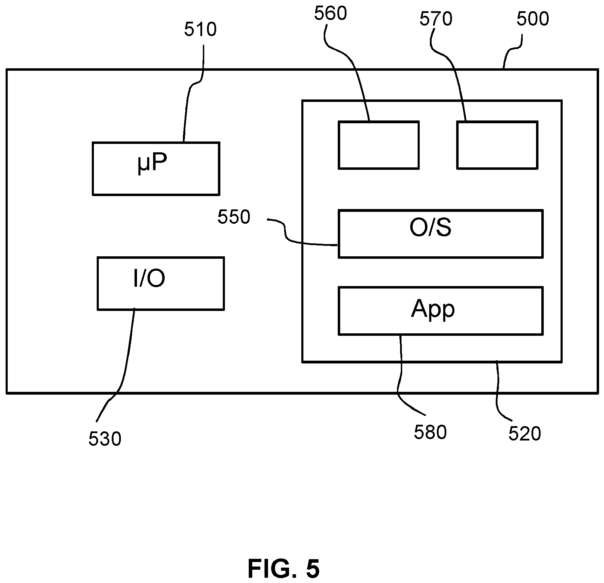

Fig. 5 illustrates an example of a computer 500 within which one or more parts of an embodiment may be employed. Various operations discussed above may utilize the capabilities of the computer 500. For example, one or more parts of a system for MRI examination of a subject may be incorporated in any element, module, application, and/or component discussed herein. In this regard, it is to be understood that system functional blocks can run on a single computer or may be distributed over several computers and locations (e.g. connected via internet).

The computer 500 includes, but is not limited to, PCs, workstations, laptops, PDAs, palm devices, servers, storages, and the like. Generally, in terms of hardware architecture, the computer 500 may include one or more processors 510, memory 520 and one or more I/O devices 530 that are communicatively coupled via a local interface (not shown). The local interface can be, for example but not limited to, one or more buses or other wired or wireless connections, as is known in the art. The local interface may have additional elements, such as controllers, buffers (caches), drivers, repeaters, and receivers, to enable communications. Further, the local interface may include address, control, and/or data connections to enable appropriate communications among the aforementioned components.

The processor 510 is a hardware device for executing software that can be stored in the memory 520. The processor 510 can be virtually any custom made or commercially available processor, a central processing unit (CPU), a digital signal processor (DSP), or an auxiliary processor among several processors associated with the computer 500, and the processor 510 may be a semiconductor based microprocessor (in the form of a microchip) or a microprocessor.

The memory 520 can include any one or combination of volatile memory elements (e.g., random access memory (RAM), such as dynamic random access memory (DRAM), static random access memory (SRAM), etc.) and non-volatile memory elements (e.g., ROM, erasable programmable read only memory (EPROM), electronically erasable programmable read only memory (EEPROM), programmable read only memory (PROM), tape, compact disc read only memory (CD-ROM), disk, diskette, cartridge, cassette or the like, etc.). Moreover, the memory 520 may incorporate electronic, magnetic, optical, and/or other types of storage media. Note that the memory 520 can have a distributed architecture, where various components are situated remote from one another, but can be accessed by the processor 510.

The software in the memory 520 may include one or more separate programs, each of which comprises an ordered listing of executable instructions for implementing logical functions. The software in the memory 520 includes a suitable operating system (O/S) 550, compiler 560, source code 570, and one or more applications 580 in accordance with exemplary embodiments. As illustrated, the application 580 comprises numerous functional components for implementing the features and operations of the exemplary embodiments. The application 580 of the computer 500 may represent various applications, computational units, logic, functional units, processes, operations, virtual entities, and/or modules in accordance with exemplary embodiments, but the application 580 is not meant to be a limitation.

The operating system 550 controls the execution of other computer programs, and provides scheduling, input-output control, file and data management, memory management, and communication control and related services. It is contemplated by the inventors that the application 580 for implementing exemplary embodiments may be applicable on all commercially available operating systems.

Application 580 may be a source program, executable program (object code), script, or any other entity comprising a set of instructions to be performed. When a source program, then the program is usually translated via a compiler (such as the compiler 560), assembler, interpreter, or the like, which may or may not be included within the memory 520, so as to operate properly in connection with the O/S 550. Furthermore, the application 580 can be written as an object oriented programming language, which has classes of data and methods, or a procedure programming language, which has routines, subroutines, and/or functions, for example but not limited to, C, C++, C#, Pascal, BASIC, API calls, HTML, XHTML, XML, ASP scripts, JavaScript, FORTRAN, COBOL, Perl, Java, ADA, .NET, and the like.

The I/O devices 530 may include input devices such as, for example but not limited to, a mouse, keyboard, scanner, microphone, camera, etc. Furthermore, the I/O devices 530 may also include output devices, for example but not limited to a printer, display, etc. Finally, the I/O devices 530 may further include devices that communicate both inputs and outputs, for instance but not limited to, a NIC or modulator/demodulator (for accessing remote devices, other files, devices, systems, or a network), a radio frequency (RF) or other transceiver, a telephonic interface, a bridge, a router, etc. The I/O devices 530 also include components for communicating over various networks, such as the Internet or intranet.

If the computer 500 is a PC, workstation, intelligent device or the like, the software in the memory 520 may further include a basic input output system (BIOS) (omitted for simplicity). The BIOS is a set of essential software routines that initialize and test hardware at start-up, start the O/S 550, and support the transfer of data among the hardware devices. The BIOS is stored in some type of read-onlymemory, such as ROM, PROM, EPROM, EEPROM or the like, so that the BIOS can be executed when the computer 800 is activated.

When the computer 500 is in operation, the processor 510 is configured to execute software stored within the memory 520, to communicate data to and from the memory 520, and to generally control operations of the computer 500 pursuant to the software. The application 580 and the O/S 550 are read, in whole or in part, by the processor 510, perhaps buffered within the processor 510, and then executed.

When the application 580 is implemented in software it should be noted that the application 580 can be stored on virtually any computer readable medium for use by or in connection with any computer related system or method. In the context of this document, a computer readable medium may be an electronic, magnetic, optical, or other physical device or means that can contain or store a computer program for use by or in connection with a computer related system or method.

The application 580 can be embodied in any computer-readable medium for use by or in connection with an instruction execution system, apparatus, or device, such as a computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the instruction execution system, apparatus, or device. The computer readable medium can be, for example but not limited to, an electronic, magnetic, optical, electromagnetic, infrared, or semiconductor system, apparatus, device, or propagation medium.

The methods of Figs. 1-3, and the system of Fig. 4, may be implemented in hardware or software, or a mixture of both (for example, as firmware running on a hardware device). To the extent that an embodiment is implemented partly or wholly in software, the functional steps illustrated in the process flowcharts may be performed by suitably programmed physical computing devices, such as one or more central processing units (CPUs) or graphics processing units (GPUs). Each process - and its individual component steps as illustrated in the flowcharts - may be performed by the same or different computing devices. According to embodiments, a computer-readable storage medium stores a computer program comprising computer program code configured to cause one or more physical computing devices to carry out an encoding or decoding method as described above when the program is run on the one or more physical computing devices.

Storage media may include volatile and non-volatile computer memory such as RAM, PROM, EPROM, and EEPROM, optical discs (like CD, DVD, BD), magnetic storage media (like hard discs and tapes). Various storage media may be fixed within a computing device or may be transportable, such that the one or more programs stored thereon can be loaded into a processor.

To the extent that an embodiment is implemented partly or wholly in hardware, the blocks shown in the block diagrams of Fig. 4 may be separate physical components, or logical subdivisions of single physical components, or may be all implemented in an integrated manner in one physical component. The functions of one block shown in the drawings may be divided between multiple components in an implementation, or the functions of multiple blocks shown in the drawings may be combined in single components in an implementation. Hardware components suitable for use in embodiments of the present invention include, but are not limited to, conventional microprocessors, application specific integrated circuits (ASICs), and field-programmable gate arrays (FPGAs). One or more blocks may be implemented as a combination of dedicated hardware to perform some functions and one or more programmed microprocessors and associated circuitry to perform other functions.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. If a computer program is discussed above, it may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted the term "adapted to" is intended to be equivalent to the term "configured to". Any reference signs in the claims should not be construed as limiting the scope.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

## Claims

1. A method for controlling magnetic resonance imaging, MRI, examination of a subject, the method comprising:
obtaining (102) video data from captured video of the subject during a preparation phase of an MRI examination;
processing (104) the video data with a motion detection algorithm to obtain motion data describing motion of the subject during the preparation phase of the MRI examination; and
determining (106) at least one of control parameters and control instructions for the MRI examination of the subject based on the motion data.

2. The method of claim 1, wherein determining (106) at least one of control parameters and control instructions comprises:
processing (108) the motion data with a translation algorithm so as to translate the motion data to at least one of a control parameter and control instruction for the MRI examination of the subject.

3. The method of claim 1 or 2, further comprising: obtaining (202) vital sign data describing one or more vital signs of the subject before/during the MRI examination, and wherein determining (206) at least one of control parameters and control instructions for MRI examination of the subject is further based on the vital sign data.

4. The method of claim 3, wherein obtaining (202) vital sign data comprises monitoring the subject's pulse and determining a heart rate of the subject before/during the MRI examination.

5. The method of any of claims 1 to 4, further comprising: obtaining (204) subject data describing one or more physiological parameters of the subject, and wherein determining (206) at least one of control parameters and control instructions for MRI examination of the subject is further based on the subject data.

6. The method of any of claims 1 to 5, wherein obtaining (102) video data comprises:
instructing (304) the subject to perform a plurality of consecutive breath-hold, BH, manoeuvres; and
obtaining (306) video data from captured video of the subject performing the plurality of consecutive BH manoeuvres,
wherein processing (104) the video data comprises processing (312) the video data with a motion detection algorithm to obtain motion data describing motion of the subject during the plurality of consecutive BH manoeuvres,
and wherein determining at least one of control parameters and control instructions comprises:
determining (324) a BH capability of the subject based on the motion data; and
generating (326) a control instruction for setting at least one of: a number of BH manoeuvres to be instructed during the MRI examination; a BH recovery time; and a maximum duration of the MRI examination.

7. The method of claim 6, wherein determining a BH capability of the subject comprises:
providing (322) the motion data as input to a machine-learning algorithm, the machine-learning algorithm being trained to predict (324), for the subject associated with the motion data, a BH value indicating a breath-hold capability of the subject,
and optionally wherein the BH value comprises at least one of: a maximum number of achievable BH manoeuvres; a maximum achievable BH length; and a BH recovery time.

8. The method of claim 7, wherein the machine-learning algorithm is trained using a training algorithm configured to receive an array of training inputs and respective known outputs, wherein a training input comprises motion data associated with a subject and respective known output comprises a breath-hold value indicating a breath-hold capability of the subject.

9. The method of any of claims 1 to 8, wherein determining (106) at least one of control parameters and control instructions comprises:
determining, based on the motion data, a motion severity value describing a severity of the motion of the subject during the preparation phase of the MRI examination; and
determining, based on the motion severity value, a first motion compensation value for a motion compensation algorithm of the MRI examination.

10. The method of any of claims 1 to 9, wherein determining (106) at least one of control parameters and control instructions comprises:
determining, based on the motion data, a motion pattern value describing a pattern of motion of the subject during the preparation phase of the MRI examination; and
determining, based on the motion pattern value, a second motion compensation value for a motion compensation algorithm of the MRI examination.

11. The method of any of claims 1 to 10,
wherein determining (106) at least one of control parameters and control instructions comprises:
determining, based on the motion data, an instruction for an operator of the MRI examination.

12. The method of any of claims 1 to 11, wherein the motion detection algorithm employs a neural network, the neural network being trained to predict, for input video data from captured video of a subject, one or more anatomical landmarks of the subject
and wherein the motion detection algorithm is configured to a determine a region of interest, ROI, of the subject based a prediction result from the neural network and to determine motion data describing motion of the ROI of the subject based on the video data.

13. The method of any of claims 1 to 12, further comprising:
reconstructing an MRI image of the subject acquired during the MRI examination retrospectively based on the motion data.

14. A computer program comprising code means for implementing the method of any preceding claim when said program is run on a processing system.

15. A system for controlling magnetic resonance imaging, MRI, examination of a subject, the system comprising:
an input interface (410) configured to obtain video data from captured video (415) of the subject during a preparation phase of an MRI examination;
a processor (430) arrangement configured to process the video data with a motion detection algorithm to obtain motion data describing motion of the subject during the preparation phase of the MRI examination; and
a data analysis unit (440) configured to determine at least one of control parameters and control instructions for MRI examination of the subject based on the motion data.
